# EUROPEAN PATENT APPLICATION

(11) **EP 3 276 450 A1**
(43) Date of publication of application: **31.01.2018**
(21) Application number: 17174229.9
(22) Date of filing: 02.06.2017
(51) Int. Cl.: G06F 3/01, B06B 1/06, H01L 41/09

(54) **PIEZOELECTRIC VIBRATING MODULE AND ELECTRONIC DEVICE HAVING THE SAME**

(30) Priority: 27.07.2016 KR 20160095654; 03.03.2017 KR 20170027768
(71) Applicant: Moda-Innochips Co., Ltd., Danwon-gu, Ansan-si Gyeonggi-do 15433 (KR)
(72) Inventor: PARK, In Kil, 13582 Seongnam-Si (KR); PARK, Sung Chol, 15444 Ansan-Si (KR); KIM, Young Sul, 04572 Seoul (KR); LEE, Yu Hyeong, 18337 Hwaseong-Si (KR); PARK, Wan, 15244 Ansan-Si (KR)
(74) Representative: Michalski Hüttermann & Partner Patentanwälte mbB

(57) **Abstract**

Provided is a piezoelectric vibrating module including a case provided therein with a predetermined space, a piezoelectric vibrating member provided in the case, vibrating according to an applied voltage, and including a piezoelectric element; a weight member provided in the case and provided to be in contact with a portion of the piezoelectric vibrating member; and at least one fixing ember provided in one region of the piezoelectric vibrating member to contact and fix the weight member.

## Description

### BACKGROUND

The present disclosure relates to a piezoelectric vibrating module, and more particularly, to a piezoelectric vibrating module and an electronic device having the same which are used as a haptic feedback means in the electronic device.

Piezoelectric materials generate a voltage when pressure is applied thereto (piezoelectric effect), and generate an increase or decrease in volumes or lengths thereof due to a change in the pressure therein when a voltage is applied thereto (inverse piezoelectric effect). Piezoelectric vibrating modules are widely adopted, by using the inverse piezoelectric effect, for various electronic devices such as mobile phones, portable multimedia player (PMP), and game machines.

The piezoelectric vibrating module used for mobile phones and the like may be used as a haptic feedback means which responds to user's touch with a vibration. Haptic feedback refers to a sense of touch which can be sensed by user's fingertip (tip of a finger or a stylus pen) when the user touches an object. The haptic feedback means can be said most ideal if the haptic feedback means can reproduce a dynamic characteristic (vibration, touch sense, and operation sound, etc. transferred to a finger when a button is pressed) with a responsibility similar to that in case of touching an actual object (actual button) when a person touches a virtual object (e.g., a button display on a window screen). Accordingly, the piezoelectric vibrating module needs to provide a sufficient vibration force by which a person can sense a vibration through a sense of touch.

As an example of such a piezoelectric vibrating module, Korean Patent No. 10-0502782 (hereinafter, referred to as the related patent) discloses a piezoelectric vibrating module equipped with a plurality of piezoelectric plates on one surface or both surfaces of a vibrating plate. However, it is difficult to generate a sufficient vibration force which is required for electronic devices only with a structure similar to the related patent in which a piezoelectric plate is attached to a vibrating plate. That is, there is no practicality not only because the amplitude of vibration is too small but also because the vibration force is substantially smaller than that generated by a coin-type vibration motor, which is used nowadays and uses an electromagnet principle, or a solenoid-type vibration device.

In order to increase the vibration force, a weight member having a great mass can be used by being attached on a piezoelectric vibrating member. That is, a weight member is coupled on a piezoelectric vibrating member which generate a vibration in the vertical direction by using an adhesive or the like, thereby increasing the vibration force. Such a piezoelectric vibrating module is provided, for example, in one region in an electronic device and vibrates in the vertical direction of the electronic device, thereby providing a vibration to entire mobile phone.

However, the piezoelectric vibrating member may be damaged due to a shock in the piezoelectric vibrating module using a weight member having a great mass. That is, the weight member is coupled on to the piezoelectric vibrating member through an adhesive or the like, when a shock is applied to the piezoelectric vibrating module due to a drop of the electronic device, the weight member is detached from the piezoelectric vibrating member and a shock is applied to the piezoelectric vibrating member due to the mass of the weight member, and thus, the piezoelectric vibrating member may be damaged. As such, when being damaged, the piezoelectric vibrating member does not respond with a feedback and thereby loses the function as the piezoelectric vibrating module. In addition, when the weight member is detached, a resonant frequency of the piezoelectric vibrating module is changed, and thus, the piezoelectric vibrating module becomes incapable of vibrating with the resonant frequency.

### [Prior Art Document]

(Patent document 1) Korean Patent No. 10-0502782

### SUMMARY

The present disclosure provides a piezoelectric vibrating module capable of preventing the damage to a piezoelectric vibrating member due to external shocks and the detachment of a weight member.

The present disclosure also provides a piezoelectric vibrating module capable of preventing the weight member from being detached from the piezoelectric vibrating member by surrounding and fixing the weight member by a coupling member which is provided in one region of the piezoelectric vibrating member.

The present disclosure also provides an electronic device provided with the piezoelectric vibrating module.

In accordance with an exemplary embodiment, a piezoelectric vibrating module includes: a case provided therein with a predetermined space; a piezoelectric vibrating member provided in the case, vibrating according to an applied voltage, and including a piezoelectric element; a weight member provided in the case and provided to be in contact with a portion of the piezoelectric vibrating member; and at least one fixing ember provided in one region of the piezoelectric vibrating member to contact and fix the weight member.

The piezoelectric element may include: a base; a plurality of piezoelectric layers formed on at least one surface of the base; a plurality of inner electrodes formed between the plurality of piezoelectric layers; and outer electrodes provided outside and adapted to be connected with the plurality of inner electrodes.

A thickness of the base may be approximately 1/150 to approximately 1/3 of a thickness of the piezoelectric element.

A thickness of the piezoelectric layer may be equal to or greater than the thickness of the base or thicknesses of the inner electrodes.

A thickness of the base may be approximately 1/30 to approximately 1/3 of a thickness of the piezoelectric element.

The piezoelectric layers each may include at least one pore.

The inner electrodes may have at least one region having a different thickness.

The inner electrodes may have an area of approximately 10% to 97% of an area of the piezoelectric layers.

The piezoelectric layers may include a seed composition.

The piezoelectric layers may include: an orientation raw material composition formed of a piezoelectric material having a perovskite crystal structure; and an oxide distributed in the orientation raw material composition and having a general formula of ABO₃ (A is a dyadic metal element, and B is a tetradic metal element).

The seed composition may be oriented in a length of approximately 1 µm to approximately 20 µm in at least one direction.

The fixing member may be provided to surround side and upper surfaces of the weight member from a side surface of the piezoelectric vibrating member.

The piezoelectric vibrating module may further include receiving grooves formed in side and upper surfaces of the weight member and receiving the fixing member.

The fixing member may be formed in a width of approximately 5% to approximately 50% of a length of the weight member.

The piezoelectric vibrating module may further include at least one of an additional fixing member provided on the weight member to additionally fix the weight member, a coupling member provided to couple an edge of the piezoelectric element of the piezoelectric vibrating member comprising a vibrating plate coupled to the piezoelectric element and the vibrating plate, and a reinforcing member provided on the other surface of the other surface of the piezoelectric element which is not in contact with the vibrating plate.

The piezoelectric vibrating module may further include at least one buffer member provided in the case.

The buffer member may include at least one of: a first buffer member provided between a lower case and the piezoelectric vibrating member; a second buffer member provided between the piezoelectric vibrating member and the weight member; a third buffer member provided between the weight member and an upper case; and a fourth buffer member provided between an inner side surface of the case and a side surface of the weight member.

In accordance with another exemplary embodiment, an electronic device includes at least one piezoelectric module provided to contact a housing or a panel in accordance with an exemplary embodiment.

The electronic device may further include at least one buffer member provided in the case of the piezoelectric vibrating module.

The piezoelectric vibrating member may be fastened by using one or more of double-sided tapes, form tapes, silicone pads, screws, and coupling pins.

### BRIEF DESCRIPTION OF THE DRAWINGS

Exemplary embodiments can be understood in more detail from the following description taken in conjunction with the accompanying drawings, in which:
FIGS. 1 to 5 are views for describing a piezoelectric vibrating module in accordance with a first exemplary embodiment;
FIGS. 6 and 7 are a perspective view and a cross-sectional view of a piezoelectric element used in accordance with an exemplary embodiment;
FIGS. 8 and 9 are views for describing characteristics of a ceramic sintered body used in exemplary embodiments;
FIGS. 10 and 14 are views for describing examples and comparative examples of a ceramic sintered body used in exemplary embodiments;
FIGS. 15 and 16 are an exploded perspective view and a cross-sectional view of a piezoelectric vibrating module in accordance with a second exemplary embodiment;
FIGS. 17 and 19 are cross-sectional views of a piezoelectric vibrating module in accordance with other exemplary embodiments;
FIG. 20 is a schematic view for describing a various modified example of an exemplary embodiment;
FIGS. 21 and 22 are views for describing a coupling type of an electronic device in a piezoelectric vibrating module in accordance with exemplary embodiments; and
FIGS. 23 and 25 are views for describing a coupling type of an electronic device in a piezoelectric vibrating module in accordance with other exemplary embodiments.

### DETAILED DESCRIPTION OF EMBODIMENTS

Hereinafter, exemplary embodiments of the present invention will be described in detail with reference to the accompanying drawings. The present invention may, however, be embodied in different forms and should not be construed as limited to the embodiments set forth herein. Rather, these embodiments are provided so that this disclosure will be thorough and complete, and will fully convey the scope of the present invention to those skilled in the art.

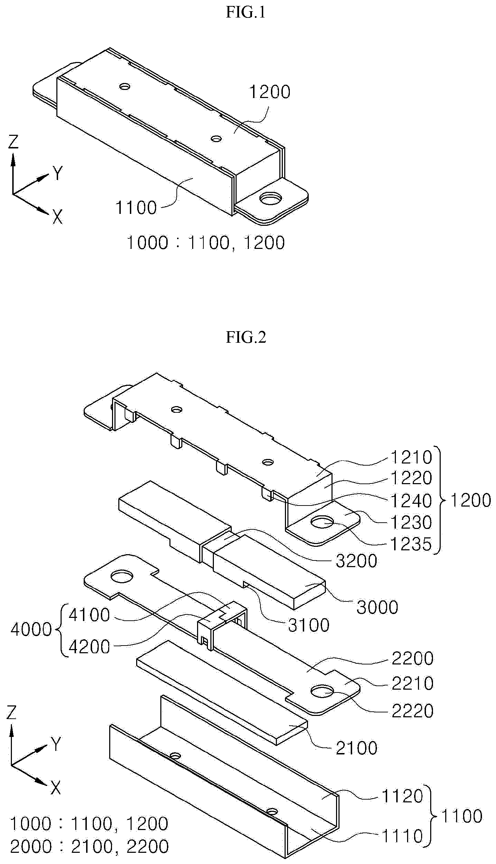

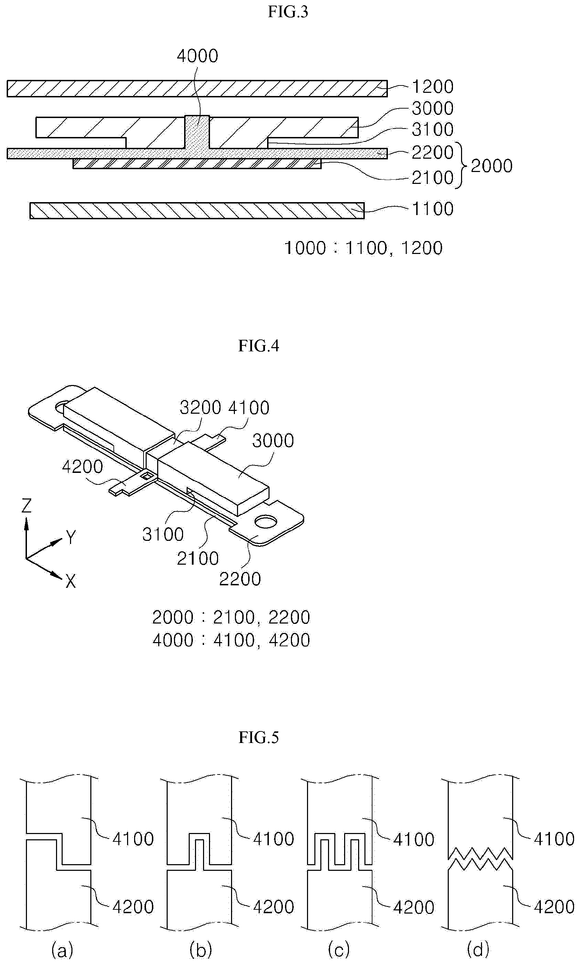

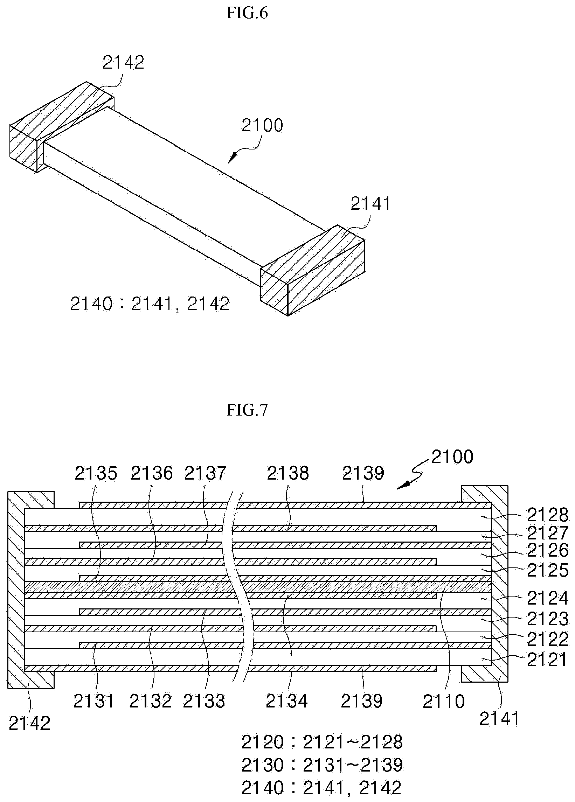

FIG. 1 is a view of a piezoelectric vibrating module in accordance with a first exemplary embodiment, and FIG. 2 is an exploded perspective view. In addition, FIG. 3 is an exploded perspective view, and FIG. 4 is a partial perspective view. Also, FIG. 5 is a schematic view of some regions of a piezoelectric vibrating module in accordance with various exemplary embodiments. Also, FIGS. 6 and 7 are a perspective view and a cross-sectional view of a piezoelectric element used in accordance with an exemplary embodiment.

Referring to FIGS. 1 to 5, a piezoelectric vibrating module in accordance with a first exemplary embodiment may include: a case 1000 provided with a space for generating vibration; a piezoelectric vibrating member 2000 provided in the inner space of the case 1000 to generate vibration; a weight member 3000 provided in the inner space of the case 1000, coupled to a portion of the piezoelectric vibrating member 2000, and amplifying the vibration of the piezoelectric vibrating member 2000; and a fixing member 4000 provided in at least one region of the piezoelectric vibrating member 2000 to fix the weight member 3000.

### 1. 1. Case

The case includes a lower case 1100 and an upper case 1200 and may have a predetermined space provided therein. That is, the lower case 1100 and the upper case 1200 are coupled to form the outer shape of the piezoelectric vibrating module, and a predetermined inner space may be provided.

The lower case 1100 is provided under the piezoelectric vibrating member 2000 and allows at least a portion of the piezoelectric vibrating member 2000 to be accommodated in the inner space. The lower case 1100 may be provided in a shape in which, for example, two sides thereof which extend in the longitudinal direction (that is, X direction) and face each other, have a first length, and two sides thereof, which extend in the width direction (that is, Y direction) perpendicular to the longitudinal direction and face each other, have a second length, wherein the first length is longer than the second length. That is, the two sides corresponding to the length of the piezoelectric vibrating member 2000 and the weight member 3000 may be provided to be long, and the two sides corresponding to the width of the piezoelectric vibrating member 2000 and the weight member 3000 may be provided to be short Also, the lower case 1100 may extend in the upward direction (that is, Z direction) from at least two sides in the longitudinal direction. That is, the lower case 1100 may include a planar part 1110 having an approximately rectangular shape and at least one side surface part 1120 upwardly extending from at least two sides of the planar part 1110. The planar part 1110 may be spaced apart a predetermined distance from the piezoelectric vibrating member 2000 to thereby cover the lower side of the piezoelectric vibrating member 2000. The side surface part 1120 may upwardly extend from at least two regions of the edges of the planar part 1110. For example, the side surface part 1120 may upwardly extend from the edges of long sides of the planar part 1110. Of course, the side surface part 1120 may upwardly extend from four edges of the planar part 1110. Here, when the side surface part 1120 extends from the four edges of the planar part 1110, at least one or more regions may be formed in heights different from each other. For example, in the side surface part 1120, one formed from a long side may be formed higher than one formed from a short side. As such, even when the side part 1120 is formed in various shapes, the side part 1120 may be coupled to the upper case 1200 to cover side surfaces. Meanwhile, the length of the planar part 1110 may be shorter than the piezoelectric vibrating member 2000. That is, the piezoelectric vibrating member 2000 may be provided to be longer than the length of the lower case 1100, and accordingly, at least a portion thereof may be exposed outside the lower case 1100. Of course, the piezoelectric vibrating member 2000 may be provided to be shorter than the length of the lower case 1100 and is thereby also completely accommodated in the lower case 1100. As such, the shape of the lower case 1100 can be variously modified.

The upper case 1200 id provided above the weight member 3000 such that the weight member 3000 is accommodated therein and at least a portion of piezoelectric vibrating member 2000 is accommodated therein. That is, the weight member 3000 may be provided inside the upper case 1200, and the piezoelectric vibrating member 2000 may be provided in the space between the lower and upper cases 1100 and 1200. The upper case 1200 may be provided in a shape in which two long sides thereof facing each other are long, and two short sides thereof facing each other are provided in the direction perpendicular to the long sides, such that an inner space is provided along the shapes of the piezoelectric vibrating member 2000 and the weight member 3000. That is, the upper case 1200 may have a shape in which two sides which are in the longitudinal direction (that is, X direction) and faces each other are long, and two sides which are in the width direction (that is, Y direction) and faces each other are short. Also, the upper case 1200 may downwardly extend from at least one region. That is, the upper case 1200 may include an approximately rectangular planar part 1210, a first extension parts 1220 extending toward the lower case 1100 from edges of the planar part 1210, and second extension parts 1230 extending in the horizontal direction from the first extension parts 1220. The planar part 1210 may be provided such that the two sides in the longitudinal direction of the piezoelectric vibrating member 2000 and the weight member 3000 are long, and the two sides in the width direction of the piezoelectric vibrating member 2000 and the weight member 3000 are short. Also, the first extension parts 1220 may downwardly extend from two edges of the planar part 1210, and may downwardly extend from at least a portion of edges of the planar part 1210. That is, the first extension parts 1220 may downwardly extend from the short sides of the planar part 1210. In addition, the second extension parts 1230 may horizontally extend from the first extension parts 1220. Accordingly, the upper case 1200 may have a shape in which two regions facing each other in the width direction thereof are curved in downward and horizontal directions. The second extension parts 1230 may be coupled to a predetermined region of the piezoelectric vibrating member 2000. Meanwhile, openings 1235 may be formed in a predetermined region of the second extension parts 1230, and corresponding to this, openings 2220 may also be formed in the piezoelectric vibrating member 2000. The openings 1235 of the upper case 1200 and the openings 2220 of the piezoelectric vibrating member 2000 are formed to align the upper case 1200 and the piezoelectric vibrating member 2000 and may be used to fix the piezoelectric vibrating module to the electronic device after assembling the piezoelectric vibrating module. Meanwhile, in the upper case 1200, a plurality of third extension parts 1240 which downwardly extend from two sides facing each other in the lengthwise direction of the planar part 1210, that is, from the long sides, may be formed. The third extension part 1240 may be provided to have a predetermined width and at a predetermined distance, and may contact the side surface part 1120 of the lower case 1100. That is, the third extension part 1240 of the upper case 1200 may be provided so as to contact the side surface part 1120 of the lower case 1100 from the outside or from the inside. Accordingly, the piezoelectric vibrating module may be realized such that the piezoelectric vibrating member 2000 and weight member 3000 are accommodated therein, the third extension parts 1240 of the upper case 1200 contact the side surface parts 1120 of the lower case 1100, and the lower case 1100 and the upper case 1200 are thereby coupled. Also, the height of each of the first and third extension parts s1220 and 1240 may be higher than the height of a portion of the piezoelectric vibrating member 2000 and the weight member 3000, such that the piezoelectric vibrating member 2000 and the weight member 3000 are accommodated between the upper case 1200 and the lower case 1100. Meanwhile, at least one hole (not shown) may be formed in at least one of the lower and upper cases 1100 and 1200 and may thereby connect an external terminal. That is, at least one hole may be formed in at least one of the planar part 1110 of the lower case 1100 and the planar part 1210 of the upper cases 1100, and an external terminal for supplying power from the outside may be introduced. The external terminal may be connected to the piezoelectric element 2100 of the piezoelectric vibrating member 2000.

### 2. 2. Piezoelectric vibrating member

The piezoelectric vibrating member 2000 may include a vibrating plate 2200 and a piezoelectric element 2100 provided on at least one surface of the vibrating plate 2200. The piezoelectric vibrating member 2000 generates vibration by using an inverse piezoelectric effect of generating a bending stress due to application of voltage. That is, the piezoelectric element 2100 is subjected to expansion and contraction motions in the vertical direction according to the applied voltage, and the vibrating plate 2200 transforms the motions into a bending deformation to generate a vibration in the vertical direction. Here, the piezoelectric element 2100 may include a base, at least one piezoelectric layer provided on at least one surface of the base, and an inner electrode. The piezoelectric element 2100 will be described in more detail by using FIGS. 6, 7, and the like. The piezoelectric element 2100 is attached to at least one surface of the vibrating plate 2200 by using an adhesive or the like. At this time, the piezoelectric element 2100 may be attached on the central portion of the vibrating plate 2200 such that both sides of the vibrating plate 2200 remain in lengths equal to each other. Also, the piezoelectric element 2100 may be attached to the upper surface of the vibrating plate 2200, may also be attached to the lower surface of the vibrating plate 2200, and may also be attached to the upper and lower surfaces of the vibrating plate 2200. That is, the present embodiment illustrates and describes the case in which the piezoelectric element 2100 is attached to the lower surface of the vibrating plate 2200, but the piezoelectric element 2100 may also be attached on the upper surface of the vibrating plate 2200, and may be attached on the upper and lower surfaces of the vibrating plate 2200. Here, the piezoelectric element 2100 and the vibrating plate 2200 may be fixed through various methods other than adhesion. For example, the vibrating plate 2200 and the piezoelectric element 2100 are adhered by using an adhesive and may also be fixed by adhering to the side surfaces of the vibrating plate 2200 and the piezoelectric element 2100 by using an adhesive or the like.

The vibrating plate 2200 may be formed by using metal, plastic, or the like, and at least a double structure may be used by laminating materials of different kinds. The piezoelectric element 2100 and the vibrating plate 2200 are manufactured in an approximately rectangular plate shape. That is, the piezoelectric element 2100 and the vibrating plate 2200 may be manufactured in shapes each having a predetermined length, width, and thickness and one and the other surface which face each other. Here, the vibrating plate 2200 may be manufactured longer than the piezoelectric element 2100. Also, the vibrating plate 2200 may be manufactured longer than the weight member 3000. In the piezoelectric vibrating member 2000, one surface of the vibrating plate 2200 contacts one surface of the piezoelectric element 2100, and the other surface of the vibrating plate 2200 contacts a portion of the weight member 3000. That is, the piezoelectric element 2100 is adhered on to the lower surface of the vibrating plate 2200, and a portion of the weight member 3000 may be coupled to the upper surface of the vibrating plate 2200. In addition, when the piezoelectric element 2100 are attached to the upper surface of the vibrating plate, the piezoelectric element 2100 and the weight member 3000 may also be in contact with and coupled to each other. Here, the piezoelectric vibrating member 2000 and the weight member 3000 may be fixed through adhesion. Also, the vibrating plate 2200 may be formed such that a predetermined region other than the region attached to the piezoelectric element 2100 may outwardly extend. That is, as illustrated in FIG. 2, an extension plate 2210 extending to the outside of the region attached to the piezoelectric element 2100 is formed, and the extension plate 2210 may contact the second extension part 1230 of the upper case 1200. In other words, the vibrating plate 2200 may include a region contacting the piezoelectric element 2100 and a region contacting the second extension part 1230 of the upper case 1200. Also, openings 2220 may be formed in the extension plate 2210 so as to correspond to the openings 1235 of the second extension part 1230. Meanwhile, a coupling region in the outer side of the vibrating plate 2200, that is, the extension plate 2210 may be provided in various shapes. For example, the extension plate 2210 may also have a shape in which the extension plate 2210 is downwardly bent, is then upwardly bent, is formed to be flat again toward the outside of the bent region, and the flat region may contact the second extension part 1230 of the upper case 1200.

### 3. 3. Weight member

The weight member 3000 has an approximately hexahedral shape having a predetermined length, width and thickness. Also, the weight member 3000 has a contact part 3100 formed on the piezoelectric vibrating member 2000 side, and the contact member 3100 contacts the piezoelectric vibrating member 2000. That is, the contact part 3100 may be provided on the central portion of one surface of the weight member 3000 in the thickness direction of the weight member 3000 which faces one surface of the piezoelectric vibrating member 2000, and may thereby contact the central portion of the piezoelectric vibrating member 2000. The contact part 3100 may be formed to protrude on the central portion of one surface of the weight member 3000 which is provided to be flat so as to be horizontal. One surface of the weight member 3000 is formed to be inclined by a predetermined angle from an edge toward the central portion, and the highest portion of the central portion may serve as the contact part 3100 and contact the piezoelectric vibrating member 2000. Here, the contact part 3100 and the piezoelectric vibrating member 2000 may be fixed by being adhered using an adhesive or the like. That is, the weight member 3000 may be firstly fixed to the piezoelectric vibrating member 2000 such that an adhesion member is provided between the contact part and the piezoelectric vibrating member 2000. Here, tapes or bonds including a double-sided tape, a cushion tape, an epoxy bond, a silicon bond, a silicon pad or the like may be used as the adhesion member. Accordingly, the contact part 3100 may contact the piezoelectric vibrating member 2000, and the remaining region of the weight member 3000 may be spaced apart from the piezoelectric vibrating member 2000. However, the adhesive should also be thickly applied according to the kinds and the corresponding characteristics of the adhesive, the distance between the piezoelectric vibrating member 2000 and the weight member 3000 may increase according to the applying thickness of the adhesive, and the thickness of the piezoelectric vibrating module may thereby be increased. Accordingly, the region applied with the adhesive, that is, the contact part 3100 may have a recess part (not shown) formed to be inwardly recessed according to the applying thickness of the adhesive, and the adhesive may be applied inside the recess part. Meanwhile, the contact part 3100 may not be positioned at the central portion of the weight member and may be moved within 20% from the central portion. Accordingly, the frequency and amplitude of vibration may be adjusted. As such, the weight member coupled to the piezoelectric vibrating member 2000 load the self weight thereof to the vibration while vibrating with the piezoelectric vibrating member 2000 due to the vibration of the piezoelectric vibrating member 2000. As such, when the piezoelectric vibrating member 2000 and the weight member are coupled and the weight of the weight member is loaded, the weight of vibrating body is consequently increased, and thus, a resonant frequency is decreased while vibration force is strengthened in comparison with the case in which the piezoelectric vibrating member 2000 vibrates alone. In particular, the vibration force is maximally amplified at a specific frequency of alternating current driving voltage. The resonant frequency may have different values according to the physical specifications and properties of each of component such as the piezoelectric vibrating member 2000 and weight member 3000. Vibrating bodies generate a largest vibration when vibrating at the natural frequency thereof. When a vibrating body includes only the piezoelectric vibrating member 2000 without the weight member 3000, since the resonance point of the vibrating body is close to the natural frequency of the piezoelectric element 2100, the current value flowing through the piezoelectric element 2100 is relatively high when the piezoelectric vibrating member 2000 maximally vibrates at the resonance point thereof. In comparison, when the vibrating body includes a coupled body of the piezoelectric vibrating member 2000 and the weight member 3000, the resonance point of the vibrating body becomes much farther from the natural frequency of the piezoelectric element 2100, and when the vibrating body generates a maximal vibration at the resonance point thereof, the current value flowing through the piezoelectric element 2100 becomes relatively low. Also, since the current flowing through the piezoelectric vibrating member 2000 is lower than in the former case than in the latter case, when the weight member 3000 is used for the vibrating body, the power consumption may be greatly reduced. Meanwhile, a receiving groove 3200 in which a fixing member 4000 is received may be formed in the side and upper surfaces of the weight member 3000. That is, a concavely recessed receiving groove 3200 is formed on the region of the weight member 300 brought into contact with the fixing member 4000, and the fixing member 4000 may be inserted and received in the receiving groove 3200. The receiving groove 3200 may be formed in a depth about the thickness of the fixing member 4000 and in a width about the width of the fixing member 4000. Accordingly, the fixing member 4000 is inserted in the receiving groove 3200, and then, the side and upper surfaces of the weight member 300 may form a plane together with the fixing member 4000. Of course, the receiving groove 3200 may also be formed in a depth greater or smaller than the thickness of the fixing member. However, the width of the receiving grove 3200 is favorably formed in a width of the fixing member 4000 and accordingly, the weight member 3000 is favorably prevented from moving. As such, the fixing member 4000 is inserted in the receiving groove 3200 and may thereby further firmly fix the weight member 3000.

### 4. Fixing member

The fixing member 4000 may be provided to surround the weight member 3000 from at least one region of the piezoelectric vibrating member 2000. For example, the fixing member 4000 may include first and second fixing members which are provided to extend from two side surfaces in the X direction of the vibrating plate 2200, that is, from the long sides of the vibrating plate 2200. The fixing member 4000 may be integrally provided with the vibrating plate 2200. Of course, the fixing member 4000 is manufactured separately from the vibrating plate 2200 and then, may be fixed to one region of the vibrating plate 2200 through a method such as welding or the like. However, it is desirable that the fixing member 4000 is integrally manufactured with the vibrating plate 2200. The fixing member 4000 is formed to surround the side and upper surfaces of the weight member 3000 and the weight member 3000 may be fixed on the piezoelectric vibrating member 2000. That is, the fixing member 4000 may be formed to contact the side and upper surfaces of the weight member 3000 to be bent and contact and surround the weight member 3000. The weight member 3000 is firstly fixed on to the piezoelectric vibrating member 2000 by using an adhesive or the like, and the fixing member 4000 may more firmly fix the weight member 3000 by surrounding and fixing the weight member 3000. Meanwhile, at least a part of the bent portion of the fixing member 4000 is removed and may thereby be formed to have a width narrower or thinner than other regions. That is, as illustrated in FIG. 2, a predetermined width of the portion contacting the side surface of the vibrating plate 2200 and an opening may thereby be formed. As such, at least a portion of the fixing member 4000 is removed, and the bending of the fixing member 4000 may thereby be easily performed and more closely contact and fix the weight member 3000. The fixing member 4000 may be formed of the same material as that of the vibrating plate 2200, such as, metallic material. Meanwhile, a pair of fixing member 4000 may be formed on both sides of the vibrating plate 2200, and more than two or a plurality of pairs of fixing members may also be formed. That is, fixing members 4000 each may also be formed on one side surface and the other side surface facing the one surface, and a plurality of fixing members 4000 may be formed at predetermined intervals on one side surface and the other side surface of the vibrating plate 2200. As the fixing members 4000 are formed in a plurality of pairs, the weight member 3000 may be fixed on a plurality of regions, and thus, the weight member 3000 may be more firmly fixed than the case of fixing by one pair of fixing members 4000. Meanwhile, the fixing member 4000 may be formed in a width of approximately 5% to approximately 50% with respect to the length of the weight member 3000. That is, the width of the fixing member 4000 may be formed in a width of approximately 5% to approximately 50% of the length of the weight member 3000. This means that the width of one fixing member 4000 may be approximately 5% to 50% of the length of the weight member 3000, and the sum of the widths of the plurality of fixing members 4000 may be approximately 5% to approximately 50% of the length of the weight member 3000. Also, portions which contact each other in the fixing members 4000 may be formed in various shapes. That is, as illustrated in (a) of FIG. 5, a protruding part may be provided in one region of the first fixing member 4100, a recess part may be provided in the other region. Also, in the second fixing member 4200, a recess part and a protruding part may be provided corresponding to the protruding part and the recess part of the first fixing member 4100. In addition, as illustrated in (b) of FIG. 5, the first fixing member 4100 may have, for example, a recess part provided in the central portion thereof and the second fixing member 4200 may have a protruding part provided corresponding to the recess part. In addition, as illustrated in (c) of FIG. 5, the first fixing member 4100 may have, for example, two or more recess parts and the second fixing member 4200 may have two or more protruding parts provided corresponding to the recess parts. Also, as illustrated in (d) of FIG. 5, the first and second fixing members 4100 and 4200 may have ends formed in a teeth-shape and the ends may face each other to be coupled. As such, end portions of the first and second fixing members 4100 and 4200 face each other and are formed in various shapes, and thus, the facing areas of the first and second fixing members 4100 and 4200 may be increased, and the fixing strength of the weighting member 3000 may thereby be further increased. Meanwhile, an adhesive or a cushion material may be provided between the fixing member 4000 and the weight member 3000, that is, between the fixing member 4000 and the receiving grooves 3200. As the adhesive is provided, the coupling strength of the fixing member 4000 and the weight member 3000 may be improved. Also, as the cushion material is provided, a shock due to the coupling of the fixing member 4000 and the weight member 3000 may be alleviated, and the noise due to vibration may be reduced.

As described above, in the piezoelectric vibrating module in accordance with the first exemplary embodiment, the weight member 3000 provided on the piezoelectric vibrating member 2000 may be fixed by using the fixing member 4000 provided on one side of the piezoelectric vibrating member 2000. The fixing member 4000 may be provided to surround the weight member 3000. Accordingly, in comparison with related arts in which the weight member 3000 is attached and fixed by using an adhesive, the coupling strength of the weight member 3000 may be improved, and thus, the weight member 3000 may be prevented from being detached even by a shock such as a drop of an electronic device. Consequently, even under a strong shock, the functions of the piezoelectric vibrating module may be properly realized.

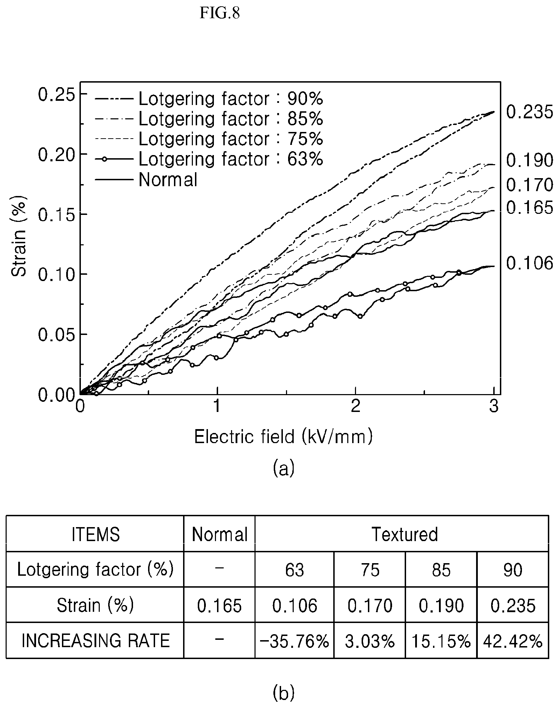

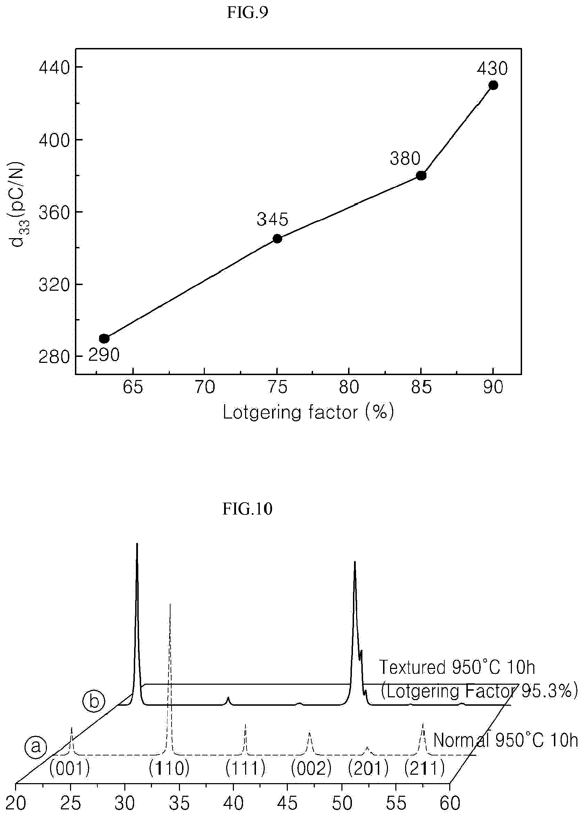

Subsequently, the piezoelectric element 2100 used as the piezoelectric vibrating member 2000 according to exemplary embodiment will be described as follows in detail with reference to drawings. FIGS. 6 and 7 are a perspective view and a cross-sectional view of a piezoelectric element in accordance with an exemplary embodiment, and FIGS. 8 and 9 are views for describing a piezoelectric element in accordance with another exemplary embodiment.

### 2.1.2.1 An example of piezoelectric element

As illustrated in FIG. 6, a piezoelectric element 2100 may be provided in a plate-like shape having a predetermined thickness. For example, the piezoelectric element 2100 may have a thickness of approximately 0.1 mm to approximately 1 mm. However, according to the size or the like of the piezoelectric vibrating module, the thickness of the piezoelectric element 2100 may be equal to the thickness range, or smaller or greater than the thickness range. Also, the piezoelectric element 2100 may have an approximately rectangular shape, but in this case, the length thereof may be longer than or equal to the width thereof. For example, the ratio of the length in the X-direction to the width in the Y-direction may be approximately 5:5 to approximately 9:1. In this case, the piezoelectric element 2100 may be provided in a size smaller than or equal to that of the vibrating plate 2200, but the length thereof in the X-direction may be smaller than the length of the vibrating plate 2200, and the width in the Y-direction is smaller than or equal to the width of the vibrating plate 2200. Of course, the piezoelectric element 2100 may be provided in various shapes, such as circles, ellipses, according to the shape of the piezoelectric vibrating module.

As illustrated in FIG. 7, the piezoelectric element 2100 may include a base 2110, at least one piezoelectric layer 2120 provided on at least one surface of the base 2110, and at least one inner electrode formed on the piezoelectric layer 2120. That is, the piezoelectric element 2100 may be formed in a bimorph type in which the piezoelectric layers 2120 are formed on both surfaces of the base 2110 or may also be formed in a unimorph type in which the piezoelectric layer 2120 are formed on one surface of the base 2110. In addition, in order to increase the displacement and the vibrating force and enable a low-voltage operation, a plurality of piezoelectric layers 2120 may also be laminated on one surface of the base 2110 and may be formed in a unimorph type. For example, as illustrated in FIG. 7, a plurality of piezoelectric layers 2121 to 2128 (2120) are laminated on one and the other surfaces of the base 2110, conductive layers are formed between the piezoelectric layers 2120, and a plurality of inner electrodes 2131 to 2138 (2130) may thereby be formed. Also, the conductive layers are formed on the surface of the piezoelectric layer 2120 and surface electrodes 2139 may be formed. Meanwhile, at least one of the inner electrodes 2130 may be formed on the surface of the base 2110, and in this case, the base 2110 may be formed of insulating materials. In addition, the piezoelectric element 2100 may further include outer electrodes 2141 and 2142 (2140) formed on the outside of the laminate so as to be connected to the inner electrodes 2130.

The base 2110 may be formed by using a material having a characteristic in which vibration may be generated while the piezoelectric layers 2120 maintain a laminated structure. For example, the base 2110 may be formed by using metal, plastic, insulating ceramic, or the like. Meanwhile, the base 2110 may be formed by not using a piezoelectric layer 2120 of metal, plastic, insulating ceramic, or the like, and a different kind of material. That is, the base 2110 may be provided by using a non-polarized piezoelectric layer. In this case, when the base 2110 is provided in a non-polarized piezoelectric layer of a metal, the inner electrode 2130 may not be formed on the surfaces of the base 2110. The base 2110 may be provided in a thickness of approximately 1/150 to approximately 1/30 with respect to the total thickness of the piezoelectric element 2100. For example, when the thickness of the piezoelectric element 2100 is approximately 300 µm, the thickness of the base 2110 may be approximately 2 µm to approximately 100 µm. In this case, the thickness of the base 2110 may be smaller than the total thickness of the piezoelectric layer 2120 and may be smaller than or equal to the thickness of each of the plurality of laminated piezoelectric layers 2120. Of course, the thickness of the base 2110 may be greater than the thickness of each piezoelectric layer 2120. However, the greater the thickness of the base 2110, the smaller the thickness of the piezoelectric layer 2120 or the smaller the number of laminated piezoelectric layers 2120, and the piezoelectric phenomenon may therefore be generated a little. Accordingly, the thickness of the base 2110 may preferably be smaller than the total thickness of the piezoelectric layer 2120 and may preferably be smaller than or equal to the thickness of each of the plurality of laminated piezoelectric layers 2120. Meanwhile, the base 2110 may be provided not only in the central portion of the piezoelectric element 2100 but also in the upper or lower portion of the piezoelectric element 2100. That is, the base 2110 may be provided on the upper or lower surface of the piezoelectric element 2100. When the base 2110 is provided on one surface of the piezoelectric element 2100, a plurality of piezoelectric layers 2120 and inner electrodes 2130 may be laminated on one surface of the base 2110. That is, the base 2110 may be used as a support layer for forming the plurality of piezoelectric layers 2120 and inner electrodes 2130. In addition, two or more bases 2110 may be provided in the piezoelectric element 2100. For example, the base 2110 may respectively be provided in the upper and lower portion of the piezoelectric element 2100 or may respectively be provided on upper, central, and lower portions of the piezoelectric element 2100. Of course, the base 2110 may be provided in any one of the upper the lower portions of the piezoelectric element 2100 and in the central portion of the piezoelectric element 2100. Meanwhile, the bases 2110 provided in the upper and lower portions of the piezoelectric element 2100 may be formed of an insulating material, and the oxidation of the surface electrodes 2139 and inner electrodes 2130 may be prevented by the insulative base 2110. That is, the insulating bases 2110 may be provided to cover the surface electrodes 2139, the insulating bases 2110 prevent the penetration of oxygen or moisture, and thus, the oxidation of the surface electrodes 2139 and the inner electrodes 2130 may be prevented. As such, even when two or more bases 2110 are provided, the total thickness of the bases 2110 may preferably smaller than the total thickness of the piezoelectric layers 2120.

The piezoelectric layers 2120 may be formed by using a piezoelectric material based on PZT(Pb, Zr, Ti), NKN(Na, K, Nb), BNT(Bi, Na, Ti). However, the piezoelectric layers 2120 may be formed by using various piezoelectric materials without being limited such materials. That is, the piezoelectric layers 2120 may be formed by using various kinds of piezoelectric materials in which a voltage is generated when a pressure is applied and an increase or decrease in the volume or length is generated due to a pressure change when a voltage is applied. Meanwhile, the piezoelectric layers 2120 may include at least one pore (not shown) formed in at least one region thereof. In this case, the pore may be formed in at least one size and shape. That is, the pore may be distributed in irregular shapes and sizes. Also, the piezoelectric layers 2120 may be polarized in at least one direction. For example, two piezoelectric layers 2120 adjacent to each other may be polarized in directions different from each other. That is, the plurality of piezoelectric layers 2120 polarized in directions different from each other may be alternately laminated. For example, first, third, sixth, and eighth piezoelectric layers 2121, 2123, 2126, and 2128 may be polarized in the downward direction, and second, fourth, fifth, and seventh piezoelectric layers 2122, 2124, 2125, and 2127 may be polarized in the upward direction.

The inner electrodes 2130 may be proved to apply a voltage applied from the outside to the piezoelectric layers 2120. That is, the inner electrodes 2130 may apply, to the piezoelectric layers 2120, a first power source for polarizing of the piezoelectric layers 2120 and a second power source for operating the piezoelectric layers 2120. The first power source for polarization and the second power source for operation may be applied to the inner electrodes 2130 through the outer electrodes 2140. The inner electrodes 2130 may be formed to be connected alternately to the outer electrodes 2140 formed on the outside of the piezoelectric element 2100. That is, the first, third, fifth, and seventh inner electrodes 2131, 2133, 2135, and 2137 may be connected to a first outer electrode 2141 and the second, fourth, sixth, and eighth inner electrodes 2132, 2134, 2136, and 2138 may be connected to a second outer electrode 2142. In addition, the inner electrodes 2130 may be formed of an insulating material, and for example, may be formed of metal or metal alloy including any one or more components of Al, Ag, Au, Pt, Pd, Ni, and Cu. In case of an alloy, for example, an alloy of Ag and Pd may be used. Meanwhile, in case of Al, aluminum oxide Al₂O₃ may be formed on a surface during burning and Al is retained inside. That is, Al contacts air when formed on the piezoelectric layers 2120, but the surface of Al is oxidized in a post-process, and Al₂O₃ is thereby formed and Al is retained inside as it is. Accordingly, the inner electrodes 2130 may be formed of Al the surface of which is coated with Al₂O₃ which is a thin porous insulating layer. Of course, besides Al, various metals on which an insulating layer, preferably, a porous insulating layer is formed may be used. Meanwhile, the inner electrodes 2130 may be formed in a thickness of, for example, approximately 1 µm to approximately 10 µm. Here, the inner electrode 2130 may be formed to have at least one region having a different thickness and may be formed such that at least one region thereof is removed. That is, the same inner electrodes 2130 may be formed such that at least one region has an irregular thickness to be smaller than or greater than other regions or may be formed such that at least one region is removed to expose the piezoelectric layers 2120. However, even when the thickness of at least one region of the inner electrodes 2130 is thin or at least one region is removed, the state of being entirely connected is maintained, and thus, there is no problem of electrical conductivity. In addition, other inner electrodes 2130 may be formed, in the same region, in thicknesses different from each other, or in shapes different from each other. That is, from among the plurality of inner electrodes 2130, at least one inner electrode 2130 in the same region corresponding to a predetermined length and width in the vertical direction may be formed in a thickness different from those of other inner electrodes 2130 or formed in a different shape. Here, the different shape may include a concave, convex, recessed shape or the like. In addition, the inner electrodes 2130 may be formed to have the length in the X-direction and the width in the Y-direction which are smaller than the length and width of the piezoelectric element 2100. That is, the inner electrodes 2130 may be formed to have the smaller length and width than those of the piezoelectric layers 2120. For example, the inner electrodes 2130 may be formed to have a length of approximately 10% to approximately 97% of the length of the piezoelectric layers 2120 and a width of approximately 10% to approximately 97% of the width of the piezoelectric layers 2120. In addition, the inner electrodes 2130 may respectively be formed to have an area of approximately 10% to approximately 97% of the area of each piezoelectric layer 2120. Meanwhile, in the piezoelectric element 2100, distances between the inner electrodes 2130 may be approximately 1/30 to approximately 1/3 with respect to the total thickness of the piezoelectric element 2100. That is, the thickness of each piezoelectric layer 2120 between the inner electrodes 2130 may be approximately 1/30 to approximately 1/3 of the total thickness of the piezoelectric element 2100. For example, when the thickness of the piezoelectric element 2100 is approximately 300 µm, the distances between the inner electrodes 2130, that is, the thickness of each piezoelectric layer 2120 may be approximately 10 µm to approximately 100 µm. An operating voltage may be changed by the distances between the inner electrodes 2130, that is, the thickness of each piezoelectric layer 2120, and the smaller the distances between the inner electrodes 2130, the smaller the operating voltage may be. However, when the distances between the inner electrodes 2130, that is, the thickness of each piezoelectric layer 2120 exceeds approximately 1/3 of the total thickness of the piezoelectric element 2100, the operating voltage is increased, and accordingly, an expensive driving IC for generating a high operating voltage is required, and this may be the cause of an increase in costs. In addition, when the distances between the inner electrodes 2130, that is, the thickness of each piezoelectric layer 2120 is smaller than approximately 1/30 of the total thickness of the piezoelectric element 2100, the frequency of generation of thickness variance is increased in a process, the thickness of the piezoelectric layers 2120 are thereby irregular, and thus, there may be a problem of deteriorating characteristics. The outer electrodes 2140 may be formed to apply the operating voltage of the piezoelectric layers 2120. To this end, the outer electrodes 2140 may be formed on at least one surface of the laminate and may be connected to the inner electrodes 2130. For example, the outer electrodes 2140 may be formed on two surfaces of the laminate which face each other in the X-direction, that is, in the lengthwise direction. Of course, the outer electrodes 2140 may be formed to extend on the two surfaces facing each other and at least one surface adjacent to the two surfaces. In addition, the outer electrodes 2140 may also pass through the laminate and may be formed in the laminate. The outer electrodes 2140 may be formed by using a method, such as printing, deposition, sputtering, or plating, and may be formed in at least one layer. For example, the outer electrodes 2140 may be formed such that a first layer contacting the laminate is formed through a printing method using a conductive paste, and a second layer is formed through a plating method. In addition, at least some regions of the outer electrodes 2140 connected to the inner electrodes 2130 may be formed of the same material as that of the inner electrodes 2130. For example, the inner electrodes 2130 may be formed of copper on the surface of the laminate, and the first layer of the outer electrodes 2130 contacting the inner electrodes 2140 may be formed of copper.

### 2.2. 2.1 Another example of piezoelectric element

Meanwhile, piezoelectric layers 2120 may also be formed by using a ceramic sintered body which is formed by sintering a piezoelectric ceramic composition including: an orientation raw material composition formed of a piezoelectric material; and a seed composition which is distributed in the orientation raw material composition and is formed of an oxide having a general formula ABO₃ (A is a dyadic metal element, and B is tetradic element). That is, a piezoelectric element 2100 may include a base 2110, piezoelectric layers 2120 formed on at least one surface of the base 2110, and inner electrodes, wherein the piezoelectric layers 2120 may include a piezoelectric ceramic sintered body including the seed composition. Here, the orientation raw material composition may be formed of a piezoelectric material having a perovskite crystalline structure. In addition, a composition in which a material having a crystalline structure different from the perovskite crystalline structure forms a solid solution may be used as the orientation raw material composition. For example, a PZT-based material in which PbTiO₃[PT] having a tetragonal structure and PbZrO3[PZ] having a rhombic structure form a solid solution may be used.

In addition, the orientation raw material composition may improve the characteristic of the PZT-based material by using a composition in which at least one of Pb(Ni,Nb)O₃[PNN], Pb(Zn,Nb)O₃[PZN], or Pb(Mn,Nb)O₃[PMN] is dissolved in the PZT-based material as a relaxor. For example, the orientation raw material composition may be formed by dissolving, as a relaxor, a PZNN-based material having a high piezoelectric characteristic and low permittivity, and sinterabiltiy by using a PZN-based material and a PNN-based material in a PZT-based material. The orientation raw material composition dissolving the PZNN-based material in the PZT-based material as a relaxor may have a empirical formula of (1-x)Pb(Zr_{0.4}7Ti_{0.53})O₃-xPb((Ni1-yZny)1/3Nb_{2/3})O₃. Here, x may have a value within a range of 0.1<x<0.5, preferably have a value within a range of 0.30 ≤ x ≤ 0.32, and most preferably have a value of 0.31. In addition, y may have a value within a range of 0.1<x<0.9, preferably have a value within a range of 0.39 ≤ x ≤ 0.41, and most preferably have a value of 0.40.

In case of piezoelectric ceramic sintered body, since the piezoelectric property is rapidly improved in a morphotropic phase boundary (MPB) region, a composition adjacent to the MPB should be found to improve the piezoelectric property. The composition of the orientation raw material composition which is sintered by adding a seed composition has a phase different from that in case of not adding the seed composition, and an excellent piezoelectric property may be derived by forming a new MPB composition according to the amount of added seed composition. Such an MPB composition may be adjusted by changing the x- and y-values of the orientation raw material composition, and when the MPB composition has the highest piezoelectric property and dielectric property when x has a value of 0.31 and y has a value of 0.40, and is therefore most preferable.

In addition, a lead-free piezoelectric material which does not include lead (Pb) may be used for the orientation raw material composition. The lead-free piezoelectric material may be a lead-free piezoelectric material including at least one piezoelectric material selected from Bi_{0.5}K_{0.5}TiO₃, Bi_{0.5}Na_{0.5}TiO₃, K_{0.5}Na_{0.5}NbO₃, KNbO₃, NaNbO₃, BaTiO₃, (1-x)Bi_{0.5}Na_{0.5}TiO₃-xSrTiO₃, (1-x)Bi_{0.5}Na_{0.5}TiO3-xBaTiO₃, (1-x)K_{0.5}Na_{0.5}NbO₃-xBi_{0.5}Na_{0.5}TiO₃, BaZr_{0.25}Ti_{0.75}O₃, or the like.

The seed composition is formed of an oxide having a general formula of ABO₃, and ABO₃ is an oxide having an oriented perovskite structure with a plate-like shape, where A is formed of a dyadic metal element, and B is formed of tetradic metal element. A seed composition formed of an oxide having a general formula of ABO₃ may include at least one of CaTiO₃, BaTiO₃, SrTiO₃, PbTiO₃ or Pb(Ti,Zr)O₃, and among these, when BaTiO₃ is used as the seed composition, the piezoelectric performance can be improved. When BaTiO₃ is used as the seed composition, BaTiO₃ may be manufactured such that Bi₄Ti₃O₁₂, which is an aurivillius plate-like structure, is synthesized through a salt dissolving synthesis method, and is substituted through a topochemical microcrystal conversion (TMC). Here, the seed composition may be included at a volume ratio of approximately 1 vol% to approximately 10 vol% with respect to the orientation raw material composition. When the seed composition is included at approximately 1 vol% or less with respect to the orientation raw material composition, the effect of improving the crystal orientation property due to the seed composition is very small, and when the seed composition is included more than approximately 10 vol%, the piezoelectric property of the piezoelectric ceramic sintered body is decreased. Here, when the seed composition in included at approximately 10 vol% with respect to the orientation raw material composition, the mount of strain may be maximized and an optimal piezoelectric property may be exhibited.

As described above, the piezoelectric ceramic composition including the orientation raw material composition and the seed composition has the same orientation property as the seed composition by using a templated grain growth (TGG) and grows. That is, the piezoelectric ceramic sintered body can not only be sintered even at a low temperature of approximately 1000°C or less by using, for example, BaTiO₃ as a seed composition in an orientation raw material composition having an empirical formula of 0.69Pb(Zr_{0.47}Ti_{0.53})O₃-0.31Pb((Ni_{0.6}Zn_{0.4})1/3Nb_{2/3})O₃, but also improve the crystalline orientability and maximize the amount of strain due to an electric field, and thus, has a high piezoelectric property similar to a single crystal material. That is, a seed composition for improving the crystalline orientability is added to an orientation raw material composition and is sintered to manufacture a piezoelectric ceramic sintered body, and thus, the mount of strain due to an electric field may be maximized, and the piezoelectric property may be remarkably improved.

In addition, the piezoelectric ceramic sintered body according to another exemplary embodiment may have a value of Lotgering factor equal to or greater than approximately 85%.
(a) of FIG. 8 is a graph illustrating a strain rate according to an electric field for each Lotgering factor, and (b) of FIG. 8 is a table showing an increasing rate of a strain rate for each Lotgering factor. In addition, FIG. 9 is a graph illustrating a piezoelectric constant d33 according to the Lotgering factor.

Referring to FIG. 8, it can be understood that the greater the Lotgering factor of the piezoelectric ceramic sintered body, the greater the strain rate of the piezoelectric ceramic sintered body. That is, in case of a normal piezoelectric ceramic sintered body without crystal orientation, the strain rate according to an electric field has a value of approximately 0.165%. When the crystal orientability of the piezoelectric ceramic sintered body is increased by using templated grain growth, the strain rate is decreased to approximately 0.106% by approximately 35.76% in the piezoelectric ceramic sintered body having a Lotgering factor of approximately 63%, but it can be understood that as the value of the Lotgering factor is increased to approximately 75%, 85%, and 90%, the strain rate is also increased to approximately 0.170%, 0.190%, 0.235%.

When the Lotgering factor of the piezoelectric ceramic sintered body has a value of approximately 85% or more with respect to the maximum value of 100%, the increasing rate of the strain rate due to an electric field is rapidly increased. That is, when the Lotgering factor of the piezoelectric ceramic sintered body is increased from approximately 75% to approximately 85%, the increasing rate of the strain rate has a value of approximately 12%, but when the Lotgering factor is increased from approximately 85% to approximately 90%, the increasing rate of the strain rate has a value of approximately 27%, and thus, it can be understood that an approximately 4 times of increasing rate is exhibited.

In addition, when the piezoelectric ceramic sintered body has a Lotgering factor of approximately 85% or more, the value of the piezoelectric constant d33 is rapidly increased. The piezoelectric constant d33 represents the amount of electrical charge generated in the pressing direction when a pressure is applied to a material, and as the value of the piezoelectric constant d33 becomes higher, a high-precision piezoelectric element with a better sensitivity can be manufactured. As illustrated in FIG. 9, it can be understood that when the Lotgering factor of a piezoelectric ceramic sintered body is increased from approximately 75% to approximately 85%, the piezoelectric constant d33 is increased from approximately 345 pC/N to approximately 380 pC/N by approximately 35 pC/N. However, when the Lotgering factor of the piezoelectric ceramic sintered body is increased from approximately 85% to approximately 90%, the piezoelectric constant d33 is increased from approximately 380 pC/N to approximately 430 pC/N by approximately 50 pC/N, and thereby exhibits an increasing rate of approximately 3 times or more. Accordingly, in case of the piezoelectric ceramic sintered body according to exemplary embodiment, the piezoelectric ceramic sintered body is manufactured by using an orientation raw material composition, formed of a piezoelectric material having a perovskite crystal structure, and a seed composition formed of an oxide which is distributed in the orientation raw material composition and has a general formula of ABO₃ (A is a dyadic element, and B is a tetradic element), and thus, the piezoelectric ceramic sintered body having a Lotgering factor of approximately 85% or more can be manufactured, and a piezoelectric element having an improved strain rate and a high sensitivity can be manufactured.

The characteristics of a piezoelectric layer including a seed composition according to an exemplary embodiment (an example) was compared with the characteristics of a piezoelectric layer not including the seed composition. For the example, a orientation raw material composition of 0.69Pb(Zr_{0.47}Ti_{0.53})O₃-0.31Pb((Ni_{0.6}Zn_{0.4})1/3Nb_{2/3})O₃ was synthesized by using powder of PbO, ZrO₂, TiO₂, ZnO, NiO, or Nb₂O₅ with a purity of approximately 98% or higher. In addition, Bi₄Ti₃O₁₂ which is an aurivillius plate-like structure was synthesized through a salt dissolving synthesis method, and a BaTiO₃ seed composition was synthesized through topochemical microcrystal conversion. A piezoelectric test piece was manufactured such that the seed composition is mixed to be included at approximately 10 vol% in the orientation raw material composition and the mixture is injected and molded. In addition, the piezoelectric test piece was heated at a rate of approximately 5°C per minute and a sintering process was performed for approximately 10 hours at approximately 950°C. In comparison, in the comparative example, a test piece was manufactured the same as the example except for a difference in that BaTiO₃ was not added as a seed composition. That is, in the comparative example, a test piece which had no seed composition because BaTiO₃ was not added was manufactured.

FIG. 10 is a graph which illustrates piezoelectric ceramic sintered bodies in the example and the comparative example, that is, surface X-ray diffraction patterns of a test piece (a) in the comparative example and a test piece (b) in the example. The degree of orientation in the graph was calculated according to a calculation equation of a Lotgering factor, and description on the calculation equation and the specific process for calculating the Lotgering factor will not be provided. As illustrated in FIG. 10, it can be understood that the test piece (a) in the comparative example grew in all crystalline direction on a surface, and in particular, crystals remarkably grew in the normal direction of the (110) plane. On the other hand, the test piece (b) in the example, crystals grew only in the normal direction of the (001) plane on a surface and in the normal direction of the (002) plane having the same direction as the (001) plane, and the growth of the crystals is suppressed in the normal direction of the (110) plane in the comparative example. In addition, heights in the graph shows the intensity of X-ray peaks, and it could be understood that in case of the test piece (b) in the example, the Lotgering factor had a value of approximately 95.3% from each of X-ray peak intensities. Through this, it can be assured that the piezoelectric ceramic sintered body including a seed composition grew and was oriented in the (001) direction and the crystalline orintability were remarkably improved.

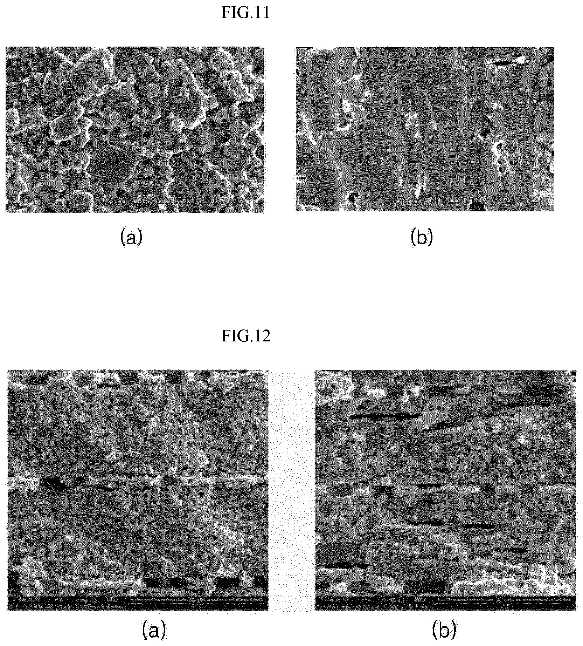

FIG. 11 is an image showing a scanned electronic microscopic image of a piezoelectric ceramic sintered body. That is, (a) of FIG. 11 is a cross-sectional image of a piezoelectric test piece manufactured through the comparative example, and (b) of FIG. 11 is a cross-sectional image of a piezoelectric test piece manufactured through the example. As shown in (a) of FIG. 11, it can be understood that in case of a piezoelectric ceramic sintered body which does not include a seed composition, particles grew in hexagonal shapes. This corresponds to the result of FIG. 10 in which crystals grew in a plurality of plane directions. On the other hand, as illustrated in (b) of FIG. 11, it can be assured that a piezoelectric ceramic sintered body, which includes a seed composition, grew in rectangular shapes due to the seed compositions (black regions in (b) of FIG. 11) which is horizontally positioned, and thus, the crystalline orientability was improved.

In addition, FIG. 12 is a cross-sectional image of a piezoelectric element using a piezoelectric ceramic sintered body as a piezoelectric layer. That is, (a) of FIG. 12 is a cross-sectional image of a piezoelectric element using a piezoelectric ceramic sintered body according to the comparative example, and (b) of FIG. 12 is a cross-sectional image of a piezoelectric element using a piezoelectric ceramic sintered body according to the example. As shown in (b) of FIG. 12, it can be understood that seed compositions (black regions in (b) of FIG. 12) are present in the piezoelectric element using a piezoelectric ceramic sintered body according to the comparative example, and as shown in (a) of FIG. 12, seed compositions are not present in the piezoelectric element using a piezoelectric ceramic sintered body according to the comparative example. In this case, seeds are oriented in lengths of approximately 1 µm to approximately 20 µm in at least one direction. That is, the seeds each may be oriented in one direction and in at least another direction different from the one direction at the degree of orientation of approximately 1 µm to approximately 20 µm, preferably, approximately 6 µm to approximately 20 µm.

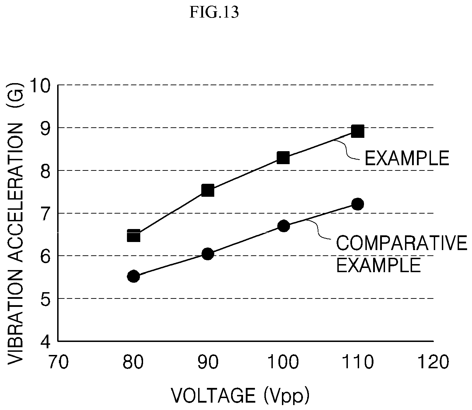

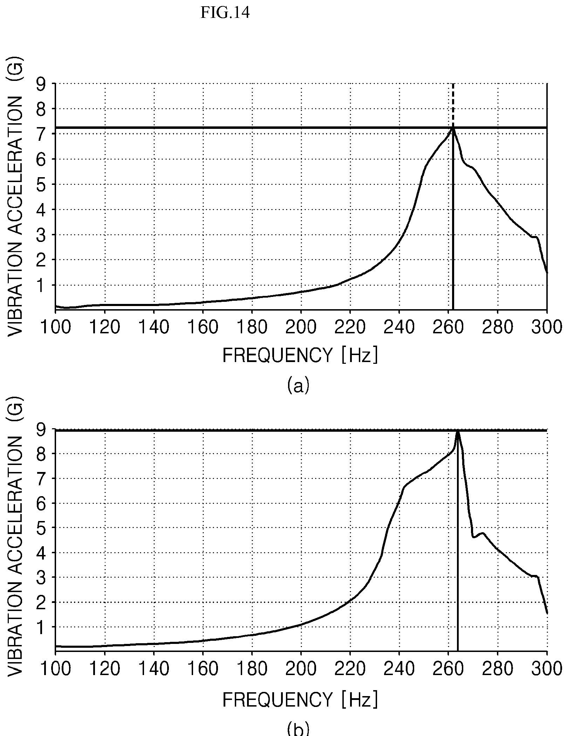

FIG. 13 is a graph in which maximum vibration accelerations of piezoelectric vibrating members provided with piezoelectric elements using, as a piezoelectric layer, a piezoelectric ceramic sintered body according to the example and the comparative example, and these are shown in Table 1. In addition, (a) and (b) of FIG. 14 illustrate frequencies at vibrating accelerations when a voltage of 110V is applied in accordance with the example and the comparative example.

**[Table 1]**

| | | 80V | 90V | 100V | 110V |
|---|---|---|---|---|---|
| Vibration acceleration [G] | Comparative example | 5.5 | 6.1 | 6.7 | 7.2 |
| | example | 6.5 | 7.5 | 8.3 | 8.9 |

As illustrated in FIG. 13 and Table 1, when a seed composition is added, the vibration acceleration can be improved at the same voltage in case of the example in which the seed composition is added in comparison with the comparative example in which the seed composition is not added. That is, for example, in case of 110V, the vibrating acceleration is increased by approximately 24% in the example in comparison with the comparative example. Accordingly, when a piezoelectric layer in which a seed composition is added is used, the vibration force of a piezoelectric vibrating member can be increased in comparison with the case in which piezoelectric layer without an added seed composition is used. That is, in piezoelectric vibrating members having the same sizes, when a piezoelectric layer in which a seed composition is added is used, the vibration force can be further increased. In addition, as illustrated in FIG. 13 and Table 1, in the example, an operating voltage for having the same vibration acceleration can be lowered. That is, since the comparative example exhibits a vibration acceleration of approximately 6.7 G at approximately 100 V, while the example exhibits a vibration acceleration of approximately 6.5 G at approximately 80 V, a smaller voltage may be applied in the example than that in the comparative example to have the same vibration acceleration as each other. In addition, as illustrated in FIG. 14, in the example, a frequency characteristic can also be improved. For example, as illustrated in (a) of FIG. 14, in the comparative example, the frequency at a vibration acceleration of approximately 4 G is approximately 245 Hz to approximately 280 Hz, and as illustrated in (b) of FIG. 14, in the example, the frequency at a vibration acceleration of approximately 4 G is approximately 230 Hz to approximately 280. Accordingly, in the example, the frequency range at the same vibration acceleration becomes wider than that in the comparative example. As a result, when a piezoelectric layer in which a seed composition is added is user, the vibration acceleration can be improved in comparison with the case in which the seed composition is not added, and the vibration force can thereby be improved. In addition, an operating voltage can be lowered and the frequency range can be increased.

### Another example

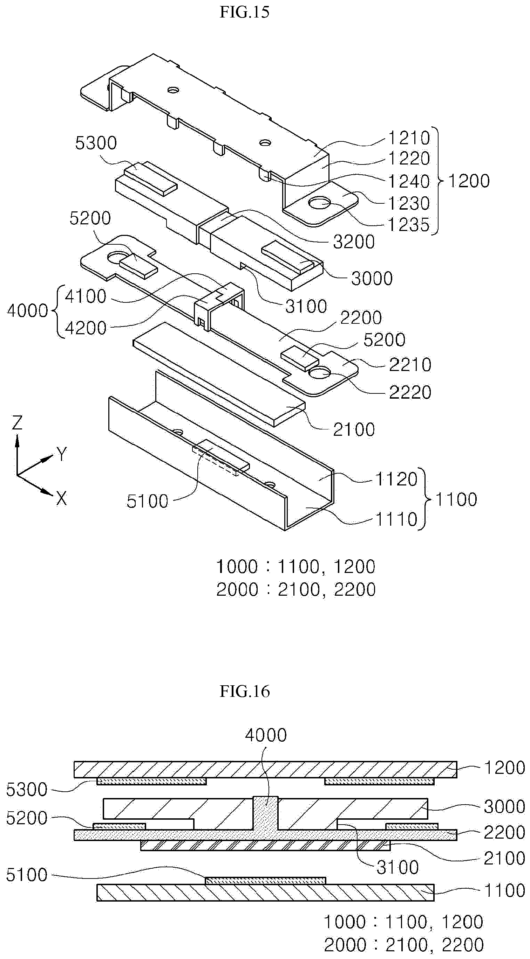

FIGS. 15 and 16 are an exploded perspective view and a cross-sectional view of a piezoelectric vibrating module in accordance with a second exemplary embodiment.

Referring to FIGS. 15 to 16, a piezoelectric vibrating module in accordance with a first exemplary embodiment may include: lower and upper cases 1100 and 1200 coupled to provide a predetermined space therein; a piezoelectric vibrating member 2000 provided in the inner space between the lower and upper cases 1100 and 1200 to generate vibration; a weight member 3000 provided in the inner space between the lower and upper cases 1100 and 1200, coupled to a portion of the piezoelectric vibrating member 2000, and amplifying the vibration of the piezoelectric vibrating member 2000; a fixing member 4000 provided in at least one region of the piezoelectric vibrating member 2000 to fix the weight member 3000, .and a buffer member 5000 for preventing damage and breakage due to external shocks.

The buffer member 5000 may be provided to prevent the damage and breakage due to external shocks, and at least one buffer member 5000 may be provided in the inner space between the lower and upper cases 1100 and 1200. For example, the buffer member 5000 may include at least one of: a first buffer member 5100 provided between the lower case 1100 and the piezoelectric vibrating member 2000; a second buffer member 5200 provided between the piezoelectric vibrating member 2000 and the weight member 3000; and a third buffer member 5300 provided between the weight member 3000 and the upper case 1200. That is, the buffer member 5000 may be provided between the lower case 1100 and the piezoelectric vibrating member 2000, between the piezoelectric vibrating member 2000 and the weight member 3000, between the weight member 3000 and the upper case 1200, or the like. Here, the first buffer member 5100 may be fixed on to the lower case 1100 and may be spaced apart a predetermined distance from the piezoelectric vibrating member 2000. The second buffer member 5200 may be fixed on to the piezoelectric vibrating member 2000 and may be spaced apart a predetermined distance from the weight member 3000. The third buffer member 5300 may be fixed on to the weight member 3000 and may be spaced apart a predetermined distance from the upper case 1200. Of course, the first buffer member 5100 may also be fixed on to the piezoelectric vibrating member 2000 facing the lower case 1100, the second buffer member 5200 may also be fixed on to the piezoelectric vibrating member 2000 facing the weight member 3000, and the third buffer member 5300 may also be fixed on to upper case 1200 facing the weight member 3000. In addition, the buffer member 5000 may also be provided between a side surface of the lower case 1100 and the weight member 3000 and/or between the side surface of the lower case 1100 and the piezoelectric vibrating member 2000. That is, a fourth buffer (not shown) provided between the inner side surface of the case and the weight member 3000 and/or between the inner side surface of the case and the piezoelectric vibrating member 2000. Meanwhile, two or more of the second buffer members 5200 and two or more of the third buffer members 5300 may also be provided. In addition, the size, that is, the length and width, of the first buffer member 5100 may be greater than the size of each of the second and third buffer members. These buffer members 5000 may be formed of rubber, phorone, silicone, or the like. In addition, the buffer members 5000 may be provided to have a predetermined restoring force or elastic force. As such, the shock applied to the inside of the piezoelectric vibrating module may be alleviated by providing the buffer members 5000, and accordingly, the collision of the internal constituents of the piezoelectric vibrating module may be prevented even by an external shock.

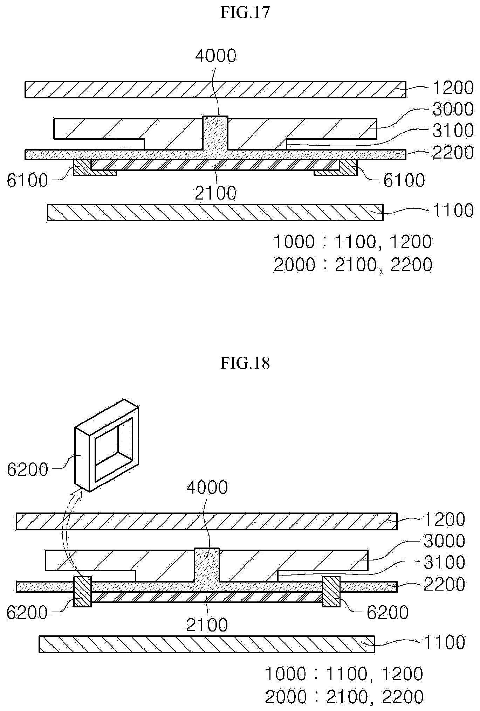

Meanwhile, the piezoelectric vibrating member 2000 may be damaged due to a shock applied into the piezoelectric vibrating module. That is, the piezoelectric vibrating member 2000, in which the piezoelectric vibrating element 2100 and the vibrating plate 2200 are coupled, is weak to an external shock and the piezoelectric vibrating element 2100 and the vibrating plate 2200 may thereby be separated. Accordingly, the coupling force of the piezoelectric vibrating member 2000 may be increased to prevent the damage to the piezoelectric vibrating member 2000. Other exemplary embodiments for this are illustrated in FIGS. 17 and 18.

As illustrated in FIG. 17, coupling members 6100 may be provided between the vibrating plate 2200 and the piezoelectric element 2100. That is, the coupling members 6100 may be formed to cover a predetermined width in an edge of the piezoelectric element 2100 and to cover a predetermined width of in an edge of the vibrating plate 2200. For example, the coupling members 6100 may be formed to cover a length or area of approximately 10% from both edges of the piezoelectric element 2100 and may be formed on the vibrating plate 2200 to have a length or area which are equal to or different from the length or area formed on the piezoelectric element 2100. In this case, when the formed length or area of the coupling members 6100 is large, the amount of generated vibration of the piezoelectric element 2100 and the vibrating plate 6200 may become smaller, and when the formed length or area of the coupling member 6100 is small, the effect of alleviating shocks may become much smaller. Therefore, the coupling members 6100 may respectively be formed in lengths or areas of approximately 5% to approximately 20% from both edges. The coupling member 6100 may be formed of a material such as epoxy, rubber.

In addition, as illustrated in FIG. 18, a band-type coupling member 6200 may also be provided to surround a predetermined region of the piezoelectric element 2100 and the vibrating plate 2200. The band-type coupling member 6200 may be formed of a material such as silicone, rubber, plastic. When the band-type coupling members 6200 are used, since the coupling force may be greatly increased than that of the coupling member 6100 illustrated in FIG. 17, a coupling effect equal to or greater than that of the coupling member 6100 while the coupling member 6200 is formed in a smaller region than the coupling member 6100. Meanwhile, buffer members 5000 may not be formed since the coupling members 6100 and 6200 are formed, and the buffer members 5000 may be formed and then, the coupling members 6100 and 6200 may also be formed.

As described above, the coupling members 6100 and 6200 are formed in a predetermined region of the piezoelectric vibrating member 2000 which is weak to shocks, and thus, the coupling force of the piezoelectric vibrating member 2000 may be increased, and the damage to the piezoelectric vibrating member 2000 due to the shocks may thereby be prevented. That is, the coupling members 6100 and 6200 are formed to firmly couple the piezoelectric element 2100 and the vibrating plate 2200, whereby the damage to the piezoelectric vibrating member 2000 due to shocks may be prevented.

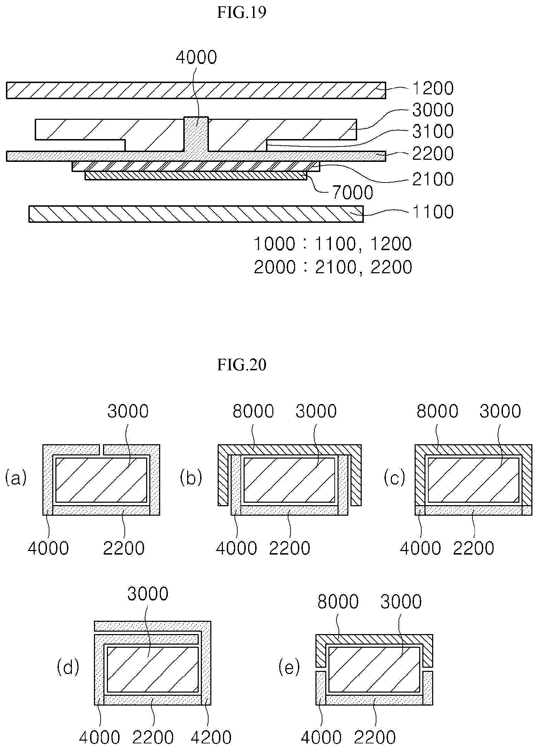

Meanwhile, as illustrated in FIG. 19, a reinforcing member 7000 may be provided in a predetermined region of the piezoelectric vibrating member 2000. For example, the reinforcing member 7000 may be provided on the other surface of the piezoelectric element 2100 which is not in contact with the vibrating plate 2200. That is, one surface of the piezoelectric element 2100 contacts the vibrating plate 2200, and the reinforcing member 7000 may be provided on the other surface of the piezoelectric element 2100. The reinforcing member 7000 may be provided to reinforce the rigidity of the piezoelectric element 2100. To this end, the reinforcing member 7000 may be formed of a material such as metal, polymer, carbon fiber, and may be provided in a size equal to or smaller than the piezoelectric element 2100. In addition, the reinforcing member 7000 may be provided in a plate-like shape with a predetermined thickness. For example, the reinforcing member 7000 may be provided in a thickness equal to or different from the piezoelectric element 2100. Of course, the reinforcing member 7000 may also be provided in the same shape as the piezoelectric element 2100, that is, a rectangular shape, and may also be provided in various shapes such as squares, rhombi, parallelograms, holes. In addition, the reinforcing member 7000 may be provided in a plurality of regions on the other surface of the piezoelectric element 2100. That is, the reinforcing member 7000 may be provided in various shapes and sizes by using various materials to ensure required rigidity of the piezoelectric element 2100. In addition, the reinforcing member 7000 may be attached through bonding by using an adhesive such as epoxy or by using a tape or the like.

FIG. 20 is a schematic view for describing various modified exemplary embodiments, and is a schematic view for describing modified exemplary embodiments of various fixing methods of a weighting member 3000 by using a fixing member 4000. FIG. 20 are cross-sectional views illustrating a piezoelectric vibrating member 2000, a weighting member 3000, and a fixing member 4000 and a separate additional fixing object, or the like.

As illustrated in (a) of FIG. 20, the fixing member 4000 may be formed to surround the weight member 3000 from a side surface of the piezoelectric vibrating member 2000 and may be fixed on to the upper surface of the weight member 3000 by welding.

As illustrated in (b) of FIG. 20, the fixing member 4000 may be brought into contact with and fixed on to the side surface of the piezoelectric vibrating member 2000, and the additional fixing member 8000 may be provided on the upper surface thereof. The additional fixing member 8000 may be provided to cover the upper and side surfaces of the weight member 3000. That is, the fixing member 4000 may be formed to contact the side surface of the weight member 3000, and the additional fixing member 8000 may be provided to surround the upper surface of the weight member 3000 and the outer surface of the fixing member 4000. In this case, the additional fixing member 8000 may be formed in an approximately "C"-like shape in which one side thereof is opened, and the other side thereof facing the one side and a side surface therebetween are closed, and may cover the weight member 300 from the upper surface of the weight member 3000.

As illustrated in (c) of FIG. 20, the additional fixing member 8000 may cover the upper and side surfaces of the weight member 3000. That is, the fixing member 4000 is not provided from the side surface of the piezoelectric vibrating member 2000, and the approximate "C"-shaped additional fixing member 8000 may be formed to cover the weight member 3000 downward from the upper surface of the weight member 3000. Accordingly, the additional fixing member 8000 may be formed to cover the upper and side surfaces of the weight member 3000. In this case, the region at which the additional fixing member 8000 and the piezoelectric vibrating member 2000 contact each other may be welded and thus, the additional fixing member 8000 and the piezoelectric vibrating member 2000 may be coupled.

As illustrated in (d) of FIG. 20, the fixing member 4000 may be formed to overlap the weight member from the upper surface of the weight member 3000. That is, one fixing member 4000 is formed to cover the upper surface of the weight member 3000 from one side surface of the weight member 3000, and the other fixing member 4000 is formed to cover the upper surface of the weight member 3000 from the other side surface of the weight member 3000. Accordingly, one fixing member 4000 and the other fixing member may be overlapped and formed on the upper surface of the weight member 3000. Of course, the one fixing member may be formed to surround the weight member 3000 from the one side surface to the upper surface and the other side surface of the weight member 3000, and the other fixing member may be formed to surround the weight member 3000 from the other side surface to the upper surface and the one side surface of the weight member 3000.

As illustrated in (e) of FIG. 20, the fixing member 4000 may be formed up to some regions of the side surface of the weight member 3000, and the additional fixing member 4000 may be formed from the upper surface of the weight member 3000 to some regions of the side surface of the weight member 3000. Accordingly, the fixing member 4000 and the additional fixing member 8000 may be brought into contact with each other on the side surface of the weight member 3000, and the contact surface is welded such that the fixing member 4000 and the additional fixing member 8000 may be coupled.

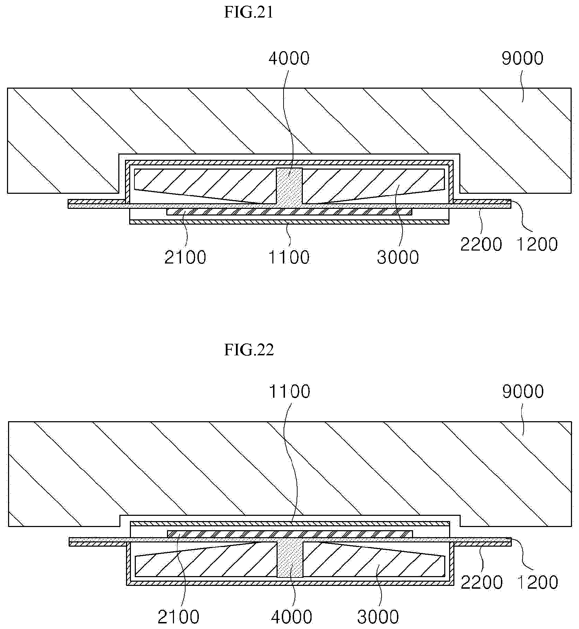

FIGS. 21 and 22 are schematic cross-sectional views for describing a coupling type of an electronic device in a piezoelectric vibrating module in accordance with exemplary embodiments. As illustrated in FIGS. 21 and 22, a predetermined space is provided in a housing 9000 of an electronic device, and at least a portion of a piezoelectric vibrating module may be inserted in the space. In this case, as illustrated in FIG. 21, an upper case 1200 may be inwardly inserted, and as illustrated in FIG. 22, a lower case 1100 may be inwardly inserted. In addition, a region in which a first extension part 1220 of the upper case 1200 and an extension part 2210 of a piezoelectric vibrating member 2000 are coupled may be fixed to the housing 9000. In this case, to reduce an error with regard to the connection and space due to vibration after assembly, an adhesive, silicone, or a metal-like pad may be attached. That is, an adhesive, silicone, a metal-like pad, or the like may be provided in a region in which the piezoelectric vibrating module and the housing 9000 face each other. In addition, the piezoelectric vibrating module may be fastened to the housing by using a fastening member through openings formed in a second extension part 1230 of the upper case 1200 and the extension plate 2210 of the piezoelectric vibrating member 2000. Screws or coupling pins may be used as the fastening member. The piezoelectric vibrating module may be firmly fixed even under a shock due to a large vibration or collision or high-temperature thermal shock by being fastened through screws or coupling pins. In this case, when nuts or bolts are used, a pressure may be distributed by using an annular part, that is, washers, which are inserted between the portions to be fixed.

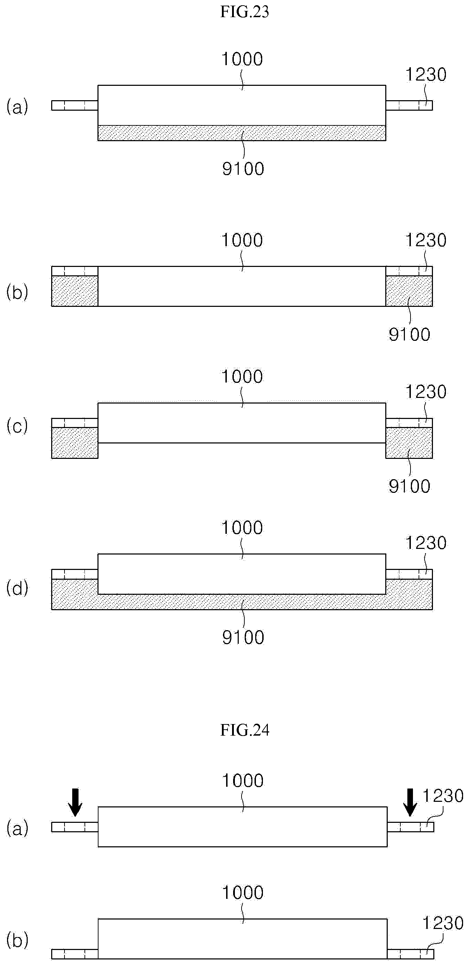

Of course, the piezoelectric vibrating module may be coupled to an electronic device through various methods. In this case, a predetermined space may also be provided in the housing 9000, but the space is not provided but the piezoelectric vibrating module may also be coupled to a surface of the housing 9000. For example, as illustrated in FIG. 23, at least one surface of a case 1000 contacting an electronic device may be applied with an adhesive member 9100 and may be adhered to and coupled to the housing 9000. That is, as illustrated in (a) of FIG. 23, except for an extension part, that is, an extension part, in which a second extension part 1230 of an upper case 1200 and an extension plate 2210 of a piezoelectric vibrating member 2000 are coupled (hereinafter, the reference number of the extension part with respect to the case is referred to as 1230), the adhesive member 9100 is applied on one surface of the case 1000 and the surface may be adhered to the housing 9000. In addition, as illustrated in (b) of FIG. 23, the extension part 1230 of the piezoelectric vibrating module is provided on one side end portion in the vertical direction of the case 1000, and the adhesive member 9100 may be applied on the extension part 1230. In this case, the extension part 1230 of the piezoelectric vibrating module may be provided in the direction facing the housing 9000, and the adhesive member 9100 may be provided between the extension part 1230 and the housing 9100. In addition, as illustrated in (c) of FIG. 23, the extension part 1230 may be formed on the central portion of the case 1000 in the vertical direction, and the adhesive member 9100 may also be provided on the extension part 1230. Alternatively, as illustrated in (d) of FIG. 23, the adhesive member 9100 may also be provided on both the extension part 1230 and one surface of the case 1000. Here, tapes and bonds including double-sided tapes, cushion tapes, epoxy bonds, silicone bonds, silicon pads or the like may be used as the adhesive member 9100.

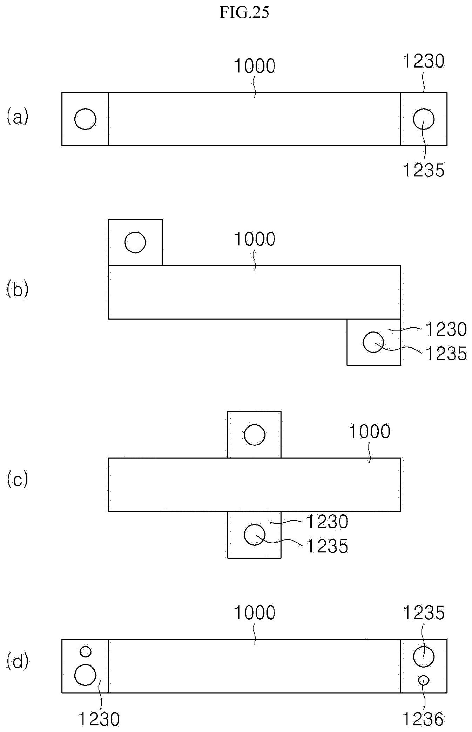

In addition, the extension part 1230 of the piezoelectric vibrating module may also be provided on the central portion of the case 1000 in the vertical direction as illustrated in (a) of FIG. 24, and as illustrated in (b) of FIG. 24, the extension part 1230 may also be provided on one side end portion of the case 1000 in the vertical direction. Fastening members are inserted into openings of the extension part 1230, and the extension part may be coupled to the housing 9000 by using the fastening members. Here, the size of the extension part 1230 may preferably be provided greater than those of the heads of the fastening members. In addition, the extension parts 1230 may also be provided, as illustrated in (a) of FIG. 25, on both end portions of a piezoelectric vibrating member in the lengthwise direction, and as illustrated in (b) of FIG. 25, one extension part 1230 may be provided on an upper end portion in the width direction crossing the lengthwise direction, and the other one extension part 1230 may also be provided on a lower end portion. In addition, as illustrated in (c) of FIG. 25, the extension parts 1230 each may be provided on the central portion of the piezoelectric vibrating member in the width direction. In this case, at least one opening 1235 is formed in each extension part 1230. Meanwhile, as illustrated in (d) of FIG. 25, a guide hole 1236 may further be formed in each extension part 1230. The guide hole may be used to align the coupling position of the piezoelectric vibrating module.

In accordance with an exemplary embodiment, a weight member provided on a piezoelectric vibrating member may be fixed by using a fixing member provided on one side of the piezoelectric vibrating member in a piezoelectric vibrating module. In addition, the fixing member may be provided to surround the weight member.

Accordingly, in comparison with related arts in which the weight member is attached and fixed by using an adhesive, the coupling force of the weight member may be improved, and thus, the weight member may be prevented from being detached even by a shock such as a drop of an electronic device. Consequently, even under a strong shock, the functions of the piezoelectric vibrating module may be properly realized.

The present invention may, however, be embodied in different forms and should not be construed as limited to the embodiments set forth herein. That is, the above embodiments are provided so that this disclosure will be thorough and complete, and will fully convey the scope of the present invention to those skilled in the art. The scope of the present invention should be interpreted by attached claims.

## Claims

1. A piezoelectric vibrating module comprising:
a case provided therein with a predetermined space;
a piezoelectric vibrating member provided in the case, vibrating according to an applied voltage, and including a piezoelectric element;
a weight member provided in the case and provided to be in contact with a portion of the piezoelectric vibrating member; and
at least one fixing member provided in one region of the piezoelectric vibrating member to contact and fix the weight member.

2. The piezoelectric vibrating module of claim 1, wherein the piezoelectric element comprising:
a base;
a plurality of piezoelectric layers formed on at least one surface of the base;
a plurality of inner electrodes formed between the plurality of piezoelectric layers; and
outer electrodes provided outside and adapted to be connected to the plurality of inner electrodes.

3. The piezoelectric vibrating module of claim 2, wherein a thickness of the base is approximately 1/150 to approximately 1/3 of a thickness of the piezoelectric element.

4. The piezoelectric vibrating module of claim 2, wherein a thickness of the piezoelectric layer is equal to or greater than the thickness of the base or thicknesses of the inner electrodes.

5. The piezoelectric vibrating module of claim 2, wherein a thickness of each of the piezoelectric layers is approximately 1/30 to approximately 1/3 of the thickness of the piezoelectric element.

6. The piezoelectric vibrating module of claim 2, wherein the piezoelectric layers each comprise at least one pore.

7. The piezoelectric vibrating module of claim 2, wherein the inner electrodes have at least one region having a different thickness.

8. The piezoelectric vibrating module of claim 2, wherein the inner electrodes have an area of approximately 10% to 97% of an area of the piezoelectric layers.

9. The piezoelectric vibrating module of claim 2, wherein the piezoelectric layers comprise a seed composition.

10. The piezoelectric vibrating module of claim 2, wherein the piezoelectric layers comprise:
an orientation raw material composition formed of a piezoelectric material having a perovskite crystal structure; and
an oxide distributed in the orientation raw material composition and having a general formula of ABO₃ (where, A is a dyadic metal element, and B is a tetradic metal element).

11. The piezoelectric vibrating module of claim 9 or claim 10, wherein the seed composition is oriented in a length of approximately 1 µm to approximately 20 µm in at least one direction.

12. The piezoelectric vibrating module of claim 1, wherein the fixing member is provided to surround side and upper surfaces of the weight member from a side surface of the piezoelectric vibrating member.

13. The piezoelectric vibrating module of claim 12, further comprising receiving grooves formed in side and upper surfaces of the weight member and receiving the fixing member.

14. The piezoelectric vibrating module of claim 1, wherein the fixing member is formed in a width of approximately 5% to approximately 50% of a length of the weight member.

15. The piezoelectric vibrating module of claim 1, further comprising at least one of:
an additional fixing member provided on the weight member to additionally fix the weight member,
a coupling member provided to couple an edge of the piezoelectric element of the piezoelectric vibrating member comprising a vibrating plate coupled to the piezoelectric element and the vibrating plate, and
a reinforcing member provided on the other surface of the other surface of the piezoelectric element which is not in contact with the vibrating plate.

16. The piezoelectric vibrating module of any one of claims 1 to 10 and claims 12 to 15, further comprising at least one buffer member provided inside the case.

17. The piezoelectric vibrating module of claim 16, wherein the buffer member comprises at least one of:
a first buffer member provided between a lower case and the piezoelectric vibrating member;
a second buffer member provided between the piezoelectric vibrating member and the weight member;
a third buffer member provided between the weight member and an upper case; and
a fourth buffer member provided between an inner side surface of the case and a side surface of the weight member.

18. An electronic device provided with at least one piezoelectric vibrating module provided so as to contact a housing or a panel,
the piezoelectric vibrating module comprising a piezoelectric vibrating module of any one of claims 1 to 10 and claims 12 to 15.

19. The electronic device of claim 18 further comprising at least one buffer member provided in the case of the piezoelectric vibrating module.

20. The electronic device of claim 18, wherein the piezoelectric vibrating member is fastened by using one or more of double-sided tapes, form tapes, silicone pads, screws, and coupling pins.
